# EUROPÄISCHE PATENTSCHRIFT

(11) **EP 1 093 706 B1**
(45) Veröffentlichungstag und Bekanntmachung des Hinweises auf die Patenterteilung: **25.09.2002**
(21) Anmeldenummer: 99945937.3
(22) Anmeldetag: 07.07.1999
(51) Int. Cl.: H05K 9/00, B60R 16/02, H05K 5/00, B29C 45/14, B32B 3/24

(54) **GEHÄUSE FÜR EINE ELEKTRONIK-EINHEIT, INSBESONDERE FÜR EIN AIRBAG-STEUERGERÄT**
HOUSING FOR AN ELECTRONICS UNIT, ESPECIALLY AN AIRBAG CONTROL DEVICE
BOITIER POUR UNITE ELECTRONIQUE, NOTAMMENT POUR APPAREIL DE COMMANDE D'AIRBAG

(30) Priorität: 07.07.1998 DE 19830227
(43) Veröffentlichungstag der Anmeldung: 25.04.2001
(73) Patentinhaber: TRW Automotive Electronics & Components GmbH & Co. KG, 78315 Radolfzell (DE)
(72) Erfinder: PETER, Cornelius, D-77815 Bühl (DE); JOHN, Harry, D-78256 Stei lingen (DE)
(74) Vertreter: Eder, Eugen, Dipl.-Ing.
(86) Internationale Anmeldenummer: DE9902100
(87) Internationale Veröffentlichungsnummer: WO00002431

(56) Entgegenhaltungen:
- CH-A- 681 971
- US-A- 5 473 109
- US-A- 5 473 111
- US-A- 5 712 765
- PATENT ABSTRACTS OF JAPAN vol. 1996, no. 09, 30. September 1996 (1996-09-30) & JP 08 139484 A (EXCEL KK), 31. Mai 1996 (1996-05-31)

## Beschreibung

Die Erfindung bezieht sich auf ein Gehäuse für eine Elektronik-Einheit, insbesondere für ein Airbag-Steuergerät, wobei zumindest die aus Metall bestehenden Wände des Gehäuses zumindest teilweise mit einem feuchtigkeitsabweisenden Überzug versehen sind.

Als allgemeiner Stand der Technik ist es bereits bekannt, insbesondere für Airbag-Steuergeräte Gehäuse aus Al-Guss zu verwenden, welche mit einem verschraubten Blechdeckel versehen sind. Nachteilig ist hierbei, dass diese bekannten Gehäuse nahezu keinen Schutz gegen Feuchtigkeit bieten. Aus diesem Grund muss die Elektronik durch Tauchen in eine entsprechende Flüssigkeit gegen Feuchtigkeit geschützt werden.

Dieser bekannte Stand der Technik weist daher Nachteile auf, nämlich eine schlechte elektromagnetische Abschirmung, wobei außerdem nach dem Tauchen der Leiterplatte eine Reparatur der Elektronik nicht mehr möglich ist. Weiterhin kann nicht ausgeschlossen werden, dass sich nach dem Tauchen noch unerwünschte Feuchtigkeit auf der Leiterplatte befindet.

Weiterhin ist eine Konstruktion bekannt (US-A-5,473,111), bei welcher das Gehäuse aus Kunststoff besteht. Hier ist vorgesehen, einzelne Wände und Decken dieses Gehäuses so zu gestalten, dass eine sehr dünne Metallfolie oder Drahtfolie, beispielsweise von 30 bis 60mµ im Durchmesser in das Kunststoff eingebettet wird, um eine gute elektromagnetische Abschirmung zu bewirken. Diese sehr dünne Metallschicht hat damit keinerlei tragende Funktion.

Entsprechend liegt der vorliegenden Erfindung die Aufgabe zugrunde, ein Gehäuse der eingangs genannten Art zu schaffen, bei welchem eine gute elektromagnetische Abschirmung gewährleistet ist, wobei außerdem die Reparaturfreundlichkeit erhöht werden soll und eine Reduzierung der Feuchtigkeitsempfindlichkeit gegeben ist.

Diese Aufgabe wird erfindungsgemäß dadurch gelöst, dass das Gehäuse aus gebogenen und miteinander verbundenen Blechelementen besteht, welche zumindest einseitig mit Kunststoff als Überzug umspritzt sind. Erfindungsgemäß findet also ein gebogenes Blechgehäuse Anwendung, welches anschließend einoder doppelseitig mit Kunststoff umspritzt wird. Hierdurch wird das Gehäuse vorteilhafterweise wasserdicht.

Durch die Umspritzung mit Kunststoff ist es möglich, Funktionselemente (Halteschienen oder Dichtflächen) zu verwirklichen.

Das erfindungsgemäße Gehäuse bietet weiterhin den Vorteil, dass für die elektromagnetische Abschirmung das günstigste Material oder die günstigste Materialkombination eingesetzt werden kann. Das Gehäuse ist in Verbindung mit einem eingesetzten Stecker absolut wasserdicht ausgeführt. Ein Tauchen der Leiterplatte ist damit nicht mehr erforderlich.

Weiterhin ergeben sich Kostenvorteile bei der Fertigung; eine "Beatmung" des Gehäuses kann über eine Belüftungsmembran erfolgen. Darüber hinaus kann die eingeschlossene Luftmenge leicht durch die Formgebung des Kunststoffes minimiert werden. Eine Reparatur der Leiterplatte ist jederzeit möglich.

Vorteilhafte Weiterbildungen ergeben sich aus den Unteransprüchen.

Die Erfindung wird nachfolgend anhand eines in der Zeichnung dargestellten Ausführungsbeispiels näher beschrieben. In der Zeichnung zeigen:
- Fig. 1: eine schematische Seitenansicht der miteinander verbundenen Blechelemente des Gehäuses im Mittelschnitt;
- Fig. 2: eine perspektivische Ansicht des aus gebogenen und miteinander verbundenen Blechelementen bestehenden Gehäuses;
- Fig. 3: eine Draufsicht auf das Gehäuse;
- Fig. 4: einen Schnitt nach der Linie IV-IV in Fig. 3; und
- Fig. 5: einen Schnitt nach der Linie V-V in Fig. 3.

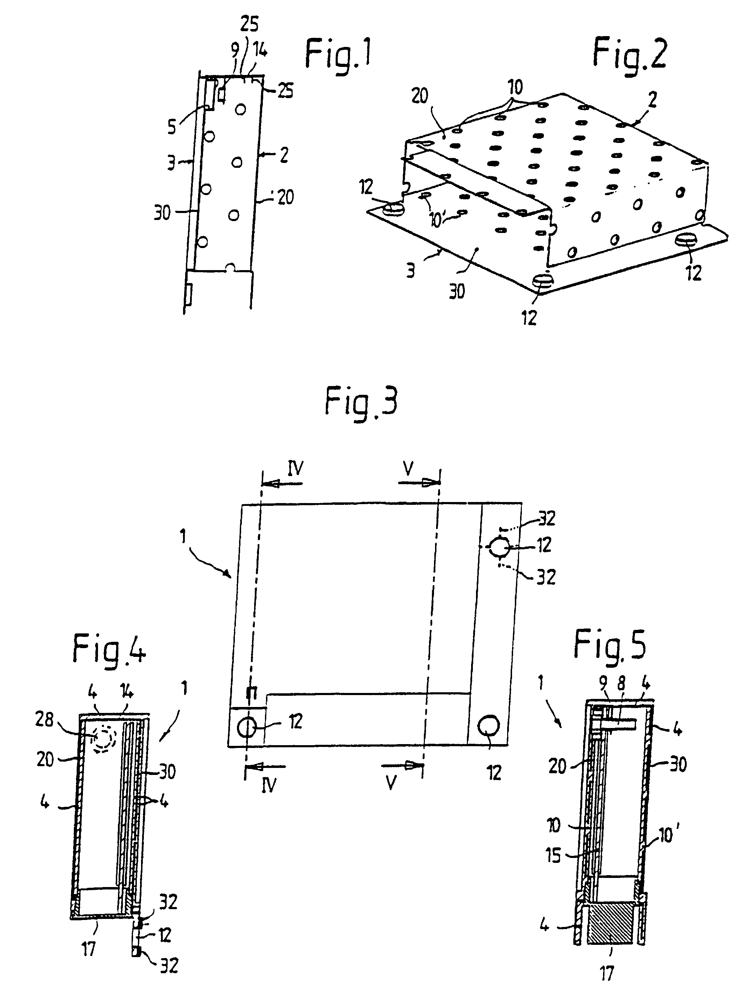

In den Fig. 3 bis 5 ist ein Gehäuse 1 für eine Elektronik-Einheit, insbesondere für ein Airbag-Steuergerät, dargestellt. Dieses Gehäuse 1 besteht aus gebogenen und miteinander verbundenen Blechelementen 2 und 3, welche zumindest einseitig mit Kunststoff 4 als Überzug umspritzt sind.

Hierbei kann das Gehäuse 1 mit den Blechelementen 2 und 3 aus einer Platine gebogen sein.

Aus den Fig. 1 und 2 geht hervor, dass alternativ die Blechelemente 2 und 3 aus einem Gehäuseoberteil 20 und einer Bodenplatte 30 bestehen können. Das Gehäuseoberteil 20 weist eine obere Deckplatte und drei Seitenwände auf.

Insbesondere aus Fig. 2 ist erkennbar, dass das Gehäuseoberteil 20 und die Bodenplatte 30 Aussparungen 10 und 10' zum Einlagern des umspritzten Kunststoffes 4 aufweisen. Es können hierbei durchgehende Aussparungen Anwendung finden.

Das Gehäuse 1 weist nach Fig. 2 innenseitig und/oder außenseitig kunststofffreie Haltebereiche auf, welche beispielsweise als Halteschienen 25 ausgebildet sind.

Aus Fig. 1 und 5 ist ersichtlich, dass in mindestens einem Blechelement 2 bzw. 3 mindestens ein Dom 5 gezogen ist. Bei dem vorliegenden Ausführungsbeispiel handelt es sich um einen Dom 5, welcher in der Bodenplatte 30 zum Einsetzen einer Erdungsschraube 8 in das Gehäuse 1 (Fig. 5) vorgesehen ist.

Gemäß Fig. 1 und 5 kann eine Seitenwand 14 des Gehäuseoberteils 20 mit einer Hülse 9 verbunden sein. In den Dom 5 und in die Hülse 9 kann dann eine Erdungsschraube 8 eingesetzt werden.

Nach Fig. 2 und 3 weist die Bodenplatte 30 mindestens eine Befestigungsöffnung 12 auf - im vorliegenden Fall sind drei Befestigungsöffnungen 12 vorgesehen.

Nach der oberern rechten Darstellung der Befestigungsöffnung 12 in Fig. 3 und nach Fig. 4 können Sicken 32 z. B. sternförmig um die Öffnung angeformt sein, welche eventuelle Oxydschichten auf einem nicht näher dargestellten Gegenstück durchdringen und so eine sichere elektrische Erdung garantieren (Prinzip Zahnscheibe).

Die Kunststoff-Ummantellung kann hierbei einseitig oder doppelseitig erfolgen. Es ist jedoch wesentlich, dass die Stirnseite der Befestigungsöffnung 12 und die Sicken 32 nicht mit Kunststoff bedeckt sind und dadurch eine sichere Erdung des Gehäuses 1 gewährleistet ist.

Nach Fig. 5 läßt sich in dem Gehäuse 1 eine Leiterplatte 15 anordnen, wobei zwischen dem Gehäuse 1 und der Leiterplatte 15 mindestens eine elektrisch leitende Verbindung vorliegt, z. B. durch die kunststofffreien Halteschienen 25 nach Fig. 1. Diese elektrisch leitende Verbindung kann auch als Federkontakt oder als Schraubenverbindung ausgebildet sein. Aus Fig. 5 ist darüber hinaus erkennbar, dass mit der Leiterplatte 15 ein Stecker 17 in Verbindung steht, welcher zumindest teilweise im Gehäuse 1 angeordnet ist.

Innerhalb des Gehäuses kann nach Fig. 4 eine Belüftungsmembran 28 angeordnet sein, wodurch auf einfache Weise eine "Beatmung" des Gehäuses 1 erfolgt. Diese Membran deckt eine Belüftungsöffnung des Gehäuses 1 ab und ist z. B. über diese geklebt oder in diese eingepresst.

Dadurch, dass die Blechelemente 2 und 3 des Gehäuses einseitig bzw. beidseitig mit Kunststoff 4 umspritzt sind, ergibt sich, dass das Gehäuse 1 in Verbindung mit dem Stecker absolut wasserdicht ausgeführt ist. Vorteilhafterweise ist damit ein Tauchen der Leiterplatte 15 nicht mehr nötig. Die Leiterplatte ist gut zugänglich, so dass eine Reparatur durchgeführt werden kann; darüber hinaus ist bei einfacher Fertigung eine sehr gute elektromagnetische Abschirmung des Gehäuses gegeben.

## Patentansprüche

1. Gehäuse (1) für eine Elektronik-Einheit, insbesondere für ein Airbag-Steuergerät, wobei zumindest die aus Metall bestehenden Wände des Gehäuses zumindest teilweise mit einem feuchtigkeitsabweisenden Überzug versehen sind,
**dadurch gekennzeichnet,**
**dass** das Gehäuse (1) aus gebogenen und miteinander verbundenen Blechelementen (2, 3) besteht, welche zumindest einseitig mit Kunststoff (4) als Überzug umspritzt sind.

2. Gehäuse nach Anspruch 1, **dadurch gekennzeichnet, dass** die Blechelemente (2, 3) doppelseitig mit Kunststoff umspritzt sind.

3. Gehäuse nach Anspruch 1 oder 2, **dadurch gekennzeichnet, dass** die Blechelemente (2, 3) aus einer Platine gebogen sind.

4. Gehäuse nach Anspruch 1 oder 2, **dadurch gekennzeichnet, dass** die Blechelemente (2, 3) aus einem Gehäuseoberteil (20) und einer Bodenplatte (30) bestehen.

5. Gehäuse nach Anspruch 4, **dadurch gekennzeichnet, dass** das Gehäuseoberteil (20) und die Bodenplatte (30) Aussparungen (10, 10') zum Einlagern des umspritzten Kunststoffes (4) aufweisen.

6. Gehäuse nach Anspruch 5, **gekennzeichnet durch** durchgehende Aussparungen (10, 10') in dem Gehäuseoberteil (20) und/oder in der Bodenplatte (30).

7. Gehäuse nach Anspruch 3 oder 4, **dadurch gekennzeichnet, dass** es innenseitig und/oder außenseitig kunststofffreie Haltebereiche aufweist.

8. Gehäuse nach einem oder mehreren der vorhergehenden Ansprüche, **dadurch gekennzeichnet, dass** in mindestens ein Blechelement (2, 3) mindestens ein Dom (5) gezogen ist.

9. Gehäuse nach Anspruch 8, **gekennzeichnet durch** einen Dom (5) in der Bodenplatte (30) zum Einsetzen einer Erdungsschraube (8) in dem Gehäuse (1).

10. Gehäuse nach Anspruch 8, **dadurch gekennzeichnet, dass** die Erdungsschraube (8) in einer mit einer Seitenwand (14) verbundenen Hülse (9) befestigt ist.

11. Gehäuse nach einem oder mehreren der vorhergehenden Ansprüche, **dadurch gekennzeichnet, dass** die Bodenplatte (30) mindestens eine Befestigungsöffnung (12) aufweist.

12. Gehäuse nach Anspruch 11, **dadurch gekennzeichnet, dass** um die Befestigungsöffnung (12) mindestens eine Sicke (32) angeformt ist.

13. Gehäuse nach einem oder mehreren der vorhergehenden Ansprüche, mit einer darin angeordneten Leiterplatte (15), **gekennzeichnet durch** mindestens eine elektrisch leitende Verbindung der Leiterplatte (15) mit dem Gehäuse (1).

14. Gehäuse nach Anspruch 13, **dadurch gekennzeichnet, dass** die elektrisch leitende Verbindung als Halteschienen (25) als Federkontakt oder als Schraubenverbindung ausgebildet ist.

15. Gehäuse nach Anspruch 13, **gekennzeichnet durch** einen mit der Leiterplatte (15) verbundenen, zumindest teilweise im Gehäuse (1) angeordneten Stecker (17).

16. Gehäuse nach einem oder mehreren der vorhergehenden Ansprüche, **gekennzeichnet durch** eine im Gehäuseinneren angeordnete Belüftungsmembran (28).

## Claims

1. Housing (1) for an electronics unit, especially an airbag control device, at least the walls of the housing, consisting of metal, being at least partly provided with a moisture-repellent covering, **characterized in that** the housing (1) comprises bent and interconnected sheet metal elements (2, 3), which are encapsulated at least on one side with plastic (4) as a covering.

2. Housing according to Claim 1, **characterized in that** the sheet metal elements (2, 3) are encapsulated with plastic on both sides.

3. Housing according to Claim 1 or 2, **characterized in that** the sheet metal elements (2, 3) are bent from one blank.

4. Housing according to Claim 1 or 2, **characterized in that** the sheet metal elements (2, 3) comprise an upper housing part (20) and a base plate (30).

5. Housing according to Claim 4, **characterized in that** the upper housing part (20) and the base plate (30) have cutouts (10, 10') for the deposition of the encapsulating plastic (4).

6. Housing according to Claim 5, **characterized by** continuous cutouts (10, 10') in the upper housing part (20) and/or in the base plate (30).

7. Housing according to Claim 3 or 4, **characterized in that** it has plastic-free holding areas on the inside and/or outside.

8. Housing according to one or more of the preceding claims, **characterized in that** at least one dome (5) is drawn in at least one sheet metal element (2, 3).

9. Housing according to Claim 8, **characterized by** a dome (5) in the base plate (30) for the insertion of an earthing screw (8) in the housing (1).

10. Housing according to Claim 8, **characterized in that** the earthing screw (8) is fixed in a sleeve (9) connected to a side wall (14).

11. Housing according to one or more of the preceding claims, **characterized in that** the base plate (30) has at least one fixing opening (12).

12. Housing according to Claim 11, **characterized in that** at least one bead (32) is integrally moulded around the fixing opening (12).

13. Housing according to one or more of the preceding claims, having a printed circuit board (15) arranged therein, **characterized by** at least one electrically conductive connection between the printed circuit board (15) and the housing (1).

14. Housing according to Claim 13, **characterized in that** the electrically conductive connection is formed as holding rails (25), as a spring contact or as a screw connection.

15. Housing according to Claim 13, **characterized by** a plug (17) which is connected to the printed circuit board (15) and at least partly arranged in the housing (1).

16. Housing according to one or more of the preceding claims, **characterized by** a ventilation diaphragm (28) arranged in the interior of the housing.

## Revendications

1. Boîtier (1) pour une unité électronique, en particulier pour un appareil de commande d'airbag, moyennant quoi au moins les parois du boîtier consistant en métal sont munies au moins partiellement d'un revêtement anti-humidité,
**caractérisé en ce que**,
le boîtier (1) consiste en éléments en tôle (2,3) pliés et raccordés entre eux qui, au moins sur un côté, reçoivent de la matière synthétique (4) encastrée par injection en tant que revêtement.

2. Boîtier selon la revendication 1, **caractérisé en ce que**, les éléments en tôle (2,3) reçoivent de la matière synthétique encastrée par injection sur les deux côtés.

3. Boîtier selon la revendication 1 ou 2, **caractérisé en ce que**, les éléments en tôle (2,3) sont pliés pour former une platine.

4. Boîtier selon la revendication 1 ou 2, **caractérisé en ce que**, les éléments en tôle (2,3) consistent en une partie supérieure de boîtier (20) et en une plaque de fond (30).

5. Boîtier selon la revendication 4, **caractérisé en ce que** la partie supérieure de boîtier (20) et la plaque de fond (30) présentent des évidements (10,10') pour recevoir de la matière synthétique (4) encastrée par injection.

6. Boîtier selon la revendication 5, **caractérisé par** des évidements traversants (10,10') dans la partie supérieure de boîtier (20) et/ou dans la plaque de fond (30).

7. Boîtier selon la revendication 3 ou 4, **caractérisé en ce qu'**il présente des zones de fixation exemptes de matière synthétique intérieurement et/ou extérieurement.

8. Boîtier selon une ou plusieurs des revendications précédentes, **caractérisé en ce que**, dans au moins un élément en tôle (2,3) il est prévu au moins un goujon (5).

9. Boîtier selon la revendication 8, **caractérisé par** un goujon (5) dans la plaque de fond (30) pour la mise en place d'une vis de mise à la terre (8) dans le boîtier (1).

10. Boîtier selon la revendication 8, **caractérisé en ce que**, la vis de mise à la terre (8) est fixée dans une douille (9) raccordée à une paroi latérale (14).

11. Boîtier selon une ou plusieurs des revendications précédentes, **caractérisé en ce que**, la plaque de fond (30) présente au moins une ouverture de fixation (12).

12. Boîtier selon la revendication 11, **caractérisé en ce que**, sur le pourtour de l'ouverture de fixation (12), il est formé au moins une moulure (32).

13. Boîtier selon une ou plusieurs des revendications précédentes, avec une carte imprimée (15) disposée dans celui-ci, **caractérisé par** au moins une connexion électriquement conductrice de la carte imprimée (15) avec le boîtier (1).

14. Boîtier selon la revendication 13, **caractérisé en ce que** la connexion électriquement conductrice en tant que glissière de fixation est conçue comme contact à ressort ou comme connexion à vis.

15. Boîtier selon la revendication 13, **caractérisé par** une fiche (17) raccordée à la carte imprimée (15), disposée au moins partiellement dans le boîtier (1).

16. Boîtier selon une ou plusieurs des revendications précédentes, **caractérisé par** une membrane d'aération (28) disposée à l'intérieur du boîtier.
